# EUROPEAN PATENT APPLICATION

(11) **EP 4 807 041 A1**
(43) Date of publication of application: **16.09.2026**
(21) Application number: 24887731.8
(22) Date of filing: 18.10.2024
(51) Int. Cl.: C23C 14/54, C23C 14/56

(54) **SUPPORT FRAME AND VACUUM APPARATUS**

(30) Priority: 08.11.2023 CN 202323009614 U
(71) Applicant: Suzhou Maxwell Technologies Co., Ltd., Suzhou, Jiangsu 215200 (CN); Suzhou Maizheng Technology Co., Ltd, Suzhou, Jiangsu 215200 (CN)
(72) Inventor: SUN, Jian, Suzhou, Jiangsu 215200 (CN); CHEN, Chen, Suzhou, Jiangsu 215200 (CN); LIU, Huan, Suzhou, Jiangsu 215200 (CN); FANG, Xianfei, Suzhou, Jiangsu 215200 (CN); SHEN, Yuliang, Suzhou, Jiangsu 215200 (CN)
(74) Representative: Balder IP Law, S.L.
(86) International application number: PCT/CN2024/125853
(87) International publication number: WO 2025/098118

(57) **Abstract**

A support frame and a vacuum apparatus, relating to the technical field of vacuum apparatus. The support frame may include a main frame, support bars and support protrusions, wherein the structure of the main frame can match the outer contour of a surface to be supported of a heating device, and a plurality of support bars are arranged in the main frame, so that an object of any shape to be supported can be supported without deformation. In addition, a plurality of support protrusions are arranged on one surface of the main frame and the support bars, and the support protrusions are in contact with the surface to be supported of the heating device. When the heating device is placed on the support frame, each support protrusion can contact the heating device and provide a certain supporting force, thereby reducing deformation of the heating device. The vacuum apparatus of the present invention uses the above support frame to support the heating device, so that deformation of the heating device can be reduced at an operating temperature.

## Description

### TECHNICAL FIELD

The present invention relates to the technical field of vacuum apparatus, and particularly relates to a support frame and vacuum apparatus.

### BACKGROUND

In existing vacuum apparatus, some heating devices need to be moved up and down during operation, so a lifting mechanism is arranged under the heating device. Since the internal temperature of the heating device is high, in order to avoid damage to the lifting mechanism caused by high temperature and heat loss inside the heating device, the lifting mechanism is generally arranged outside the heating device, and several support rods extend into the heating device to support the heating device by several support points and drive the heating device to lift.

Some heating devices are relatively large in size. When the internal temperature of the heating device rises to a high value, the lifting mechanism supports the heating device in a point-like manner at high temperature for a long time, and the heating device will deform under its own gravity, resulting in non-uniform heating during the heating process. At the same time, the deformation of the heating device itself or an uneven surface of the heated object caused by the heating device will affect the electric or magnetic field in the chamber during some vacuum thin-film deposition processes or etching processes, resulting in poor uniformity of the overall film deposition or etching in the chamber.

### SUMMARY

The present invention provides a support frame, which solves the problem of deformation of the heating device caused by the point support of the heating device by the lifting mechanism in the prior art.

In particular, the present invention further provides a support frame for supporting a heating device in vacuum apparatus, the heating device having a surface to be supported, characterized by comprising:
a main frame matching the peripheral contour of the surface to be supported of the heating device;
a plurality of support bars uniformly arranged in the main frame; and
a plurality of support protrusions arranged on a plane of the main frame and/or the plurality of support bars facing the surface to be supported, the support protrusions being in contact with the surface to be supported.

Optionally, the plurality of support protrusions are arranged symmetrically about the center.

Optionally, the support protrusions on the main frame are uniformly arranged, and the support protrusions on each of the support bars are uniformly arranged.

Optionally, one end of each support protrusion adjacent to the heating device is formed as a planar structure.

Optionally, the plurality of support bars are arranged to intersect with each other and form a centrally symmetric structure.

Optionally, the support frame is made of structural steel selected from one of H-section steel, rectangular steel, L-shaped angle steel, T-section steel, round steel, solid square steel or flat steel.

Optionally, the surface of the support frame further comprises at least one corrosion-resistant layer.

Optionally, a passage is provided in the main frame to communicate two side surfaces of the support frame, and the passage is defined by the plurality of support bars, or by a frame structure connected to the main frame via the support bars.

Optionally, the passage is arranged at a central position of the main frame.

In particular, the present invention further provides vacuum apparatus comprising the support frame described above.

Optionally, the vacuum apparatus further comprises:
a chamber;
a tray;
a heating device arranged in the chamber for heating the tray; the support frame is arranged in the chamber and located below the heating device for supporting the heating device; and
a lifting mechanism arranged outside the chamber, wherein a lifting rod of the lifting mechanism extends from outside the chamber into the chamber to contact the support frame, so as to drive the support frame to move up and down in the chamber.

In the present application, the support frame may include a main frame, support bars and support protrusions. The structure of the main frame may match the outer contour of the surface to be supported of the heating device, and a plurality of support bars are arranged in the main frame, so that an object of any shape to be supported can be supported without deformation.

In addition, a plurality of support protrusions are provided on one surface of the main frame and the support bars. While supporting the heating device, the protrusions reduce the contact area with the heating device, avoid heat transfer between the heating device and the support frame, and reduce friction caused by relative sliding. Furthermore, since the support protrusions are in contact with the surface to be supported of the heating device, each support protrusion can contact the heating device and provide a certain supporting force when the heating device is placed on the support frame, thereby reducing deformation of the heating device.

Further, the support protrusions in the present solution are uniformly arranged, which can not only support the heating device but also reduce local deformation of the heating device caused by non-uniform distribution of the support protrusions.

Further, the vacuum apparatus of the present solution may include a chamber, the support frame described above, a heating device, and a lifting mechanism. With the support frame, the lifting mechanism supports the support frame, which in turn supports the heating device, and the heating device supports the tray. Since the support frame is provided with the main frame and/or a plurality of support bars and the support protrusions arranged above the support bars, and the support protrusions are in contact with the surface to be supported of the heating device, the heating device can be fully supported so that the heating device is not easily deformed, thereby ensuring uniform heating of the tray.

According to the detailed description of the specific embodiments of the present invention with reference to the accompanying drawings, those skilled in the art will better understand the above and other objects, advantages and features of the present invention.

### BRIEF DESCRIPTION OF THE DRAWINGS

Fig. 1 is a schematic perspective diagram from one angle of a support frame according to a specific embodiment of the present invention.
Fig. 2 is a front view of the support frame according to a specific embodiment of the present invention.
Fig. 3 is an enlarged detail view of Fig. 1.
Fig. 4 is a schematic perspective diagram from another angle of the support frame according to a specific embodiment of the present invention.
Fig. 5 is a rear view of the support frame according to a specific embodiment of the present invention.
Fig. 6 is a cross-sectional view of vacuum apparatus according to a specific embodiment of the present invention.
Fig. 7 is a schematic structural diagram of a lifting mechanism and the support frame of the vacuum apparatus according to a specific embodiment of the present invention.
Fig. 8 is a schematic structural diagram of the support frame according to specific Embodiment 1 of the present invention.
Fig. 9 is a schematic structural diagram of the support frame according to specific Embodiment 2 of the present invention.
Fig. 10 is a schematic structural diagram of the support frame according to specific Embodiment 3 of the present invention.
Fig. 11 is a schematic structural diagram of the support frame according to specific Embodiment 4 of the present invention.
Fig. 12 is a schematic structural diagram of the support frame according to specific Embodiment 5 of the present invention.
Fig. 13 is a schematic structural diagram of the support frame according to specific Embodiment 6 of the present invention.

100,support frame; 110,main frame; 120, support bar; 130,support protrusion; 140, passage; 200,vacuum apparatus; 210,chamber; 220,heating device; 230, lifting mechanism; 121,transverse support bar; 122,longitudinal support bar;

### DETAILED DESCRIPTION

In the description of the present embodiment, it should be understood that the orientation or positional relationships indicated by the terms "length", "width", "height", "upper", "lower", "left", "right", "vertical", "horizontal", "bottom", "inner", "outer" and the like are based on the orientation or positional relationships shown in the drawings. They are merely for the convenience of describing the present invention and simplifying the description, and do not indicate or imply that the device or element referred to must have a specific orientation, or be constructed and operated in a specific orientation, and therefore cannot be construed as limitations on the present invention.

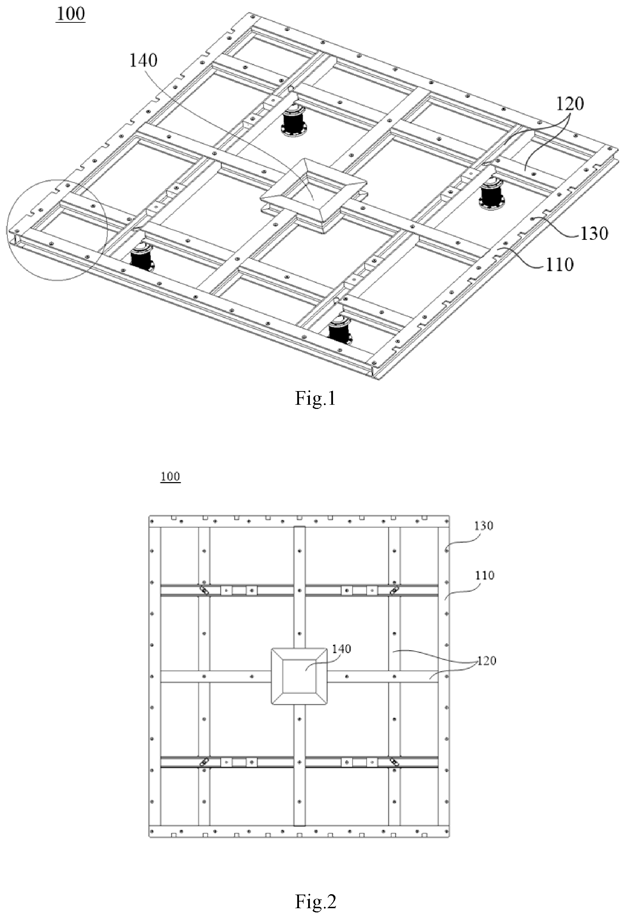

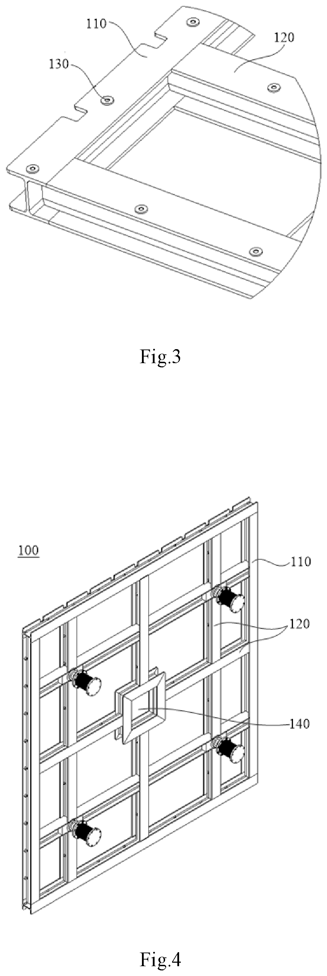

As a specific embodiment of the present invention, as shown in Figs. 1-5, the present embodiment discloses a support frame 100 for supporting a heating device having a surface to be supported. The support frame 100 may include a main frame 110, a plurality of support bars 120, and a plurality of support protrusions 130. The main frame 110 matches the peripheral contour of the surface to be supported of the heating device . The plurality of support bars 120 are uniformly arranged in the main frame 110. The plurality of support protrusions 130 are arranged on a plane of the main frame 110 and/or the plurality of support bars 120 facing the surface to be supported, and the support protrusions 130 are in contact with the surface to be supported of the heating device.

Specifically, in the present embodiment, the support frame 100 may include a main frame 110, support bars 120, and support protrusions 130. The structure of the main frame 110 may match the outer contour of a surface to be supported of the heating device. A plurality of support bars 120 are disposed within the main frame 110, so that objects to be supported of any shape can be supported and deformation of the objects can be avoided.

In addition, in the present embodiment, a plurality of support protrusions 130 are further disposed on one surface of the main frame 110 and the support bars 120. While supporting the heating device, the protrusions reduce a contact area with the heating device, avoid heat transfer between the heating device and the support frame 100, and reduce friction caused by relative sliding.

Furthermore, since the support protrusions 130 are in contact with the surface to be supported of the heating device, each support protrusion 130 can contact the heating device and provide a certain supporting force when the heating device is placed on the support frame 100, thereby reducing deformation of the heating device.

As a specific embodiment of the present invention, the support protrusions 130 at the main frame 110 in the present embodiment are uniformly arranged, and the support protrusions 130 on each support bar 120 are uniformly arranged.

Specifically, in the present embodiment, the support protrusions 130 are uniformly arranged, which can not only support the heating device but also reduce local deformation of the heating device caused by non-uniform distribution of the support protrusions 130.

As a specific embodiment of the present invention, the plurality of support protrusions 130 in the present embodiment are arranged symmetrically about the center. Since the support protrusions 130 in the present embodiment are not only uniformly arranged but also arranged symmetrically about the center, the support for the heating device by the support protrusions 130 can further reduce deformation of the heating device.

As a specific embodiment of the present invention, one end of each support protrusion 130 close to the heating device in the present embodiment is formed as a planar structure.

Specifically, in the present embodiment, the end of the support protrusion 130 close to the heating device may be a planar structure such as circular, annular, square, rectangular, etc. The specific shape can be selected according to actual conditions. When the end of the support protrusion 130 is circular, the support protrusion 130 may be cylindrical or frustoconical as a whole. When the end of the support protrusion 130 is annular, the overall structure of the support protrusion 130 may be annular cylindrical (as shown in Figs. 1-3).Compared with a point structure, the planar structure can increase the contact area between the support protrusion 130 and the heating device, thereby reducing local deformation at the contact position between the support protrusion 130 and the heating device.

As a specific embodiment of the present invention, the plurality of support bars 120 in the present embodiment are arranged to intersect with each other and form a centrally symmetric structure. The intersecting arrangement of the support bars 120 in the present embodiment can increase structural stability and, of course, further reduce deformation of the heating device.

As a specific embodiment of the present invention, the support frame 100 in the present embodiment is made of structural steel selected from one of H-section steel, rectangular steel, L-shaped angle steel, T-section steel, round steel, solid square steel or flat steel.

In the present embodiment, structural steel has high strength and is not easily deformed. Therefore, when the support frame 100 is made of structural steel, it has high strength and is not easily deformed, and meanwhile features low cost, easy processing and reusability. In addition, when the structural steel is selected from one of H-section steel, rectangular steel, L-shaped angle steel, T-section steel, round steel, solid square steel or flat steel, the strength of the support frame 100 can be further improved.

As a specific embodiment of the present invention, the surface of the support frame 100 further comprises at least one corrosion-resistant layer.

As a specific embodiment of the present invention, a passage 140 is provided in the main frame 110 in the present embodiment to communicate two side surfaces of the support frame 100.The passage 140 in the present embodiment is mainly used for passing wiring harnesses. Specifically, the passage 140 in the present embodiment may be in any shape such as circular or square.

As a specific embodiment of the present invention, the passage 140 in the present embodiment is defined by a plurality of support bars 120. Since the support bars 120 inevitably form holes and the like when arranged to intersect with each other, the holes formed by the support bars 120 can be used as the passage 140.

As another specific embodiment of the present invention, the passage 140 in the present embodiment is defined by a frame structure connected to the main frame 110 via the support bars 120. Specifically, the passage 140 in this embodiment may be a separate frame structure, which is connected to the main frame 110 via the support bars 120. Such an arrangement can further enhance the stability of the support frame 100.

As another specific embodiment of the present invention, the passage 140 in the present embodiment may be disposed at a central position or other positions of the main frame 110. Specifically, the position of the passage 140 in the present embodiment can be designed according to actual conditions, and disposing it at the central position is more conducive to application in different products.

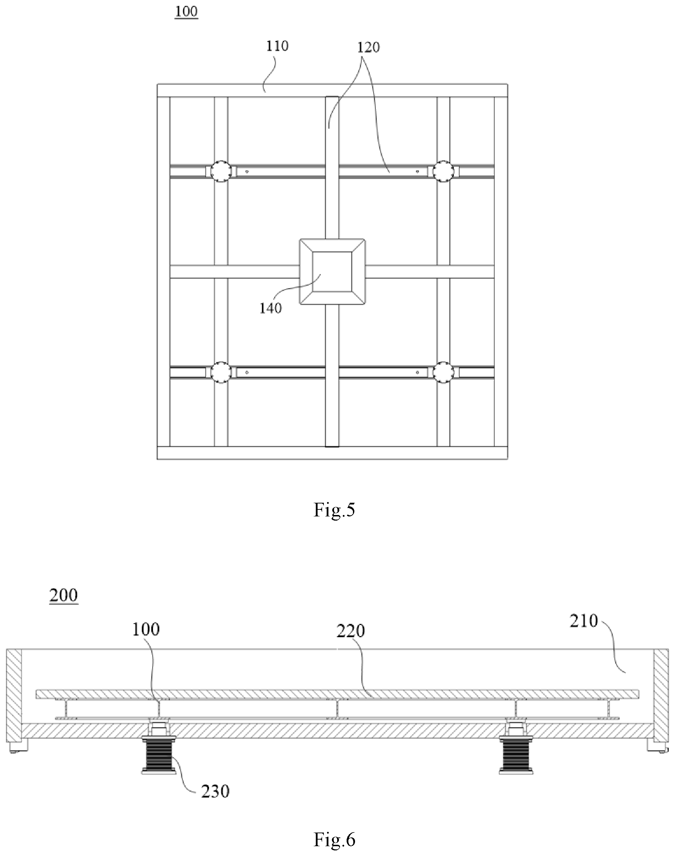

As a specific embodiment of the present invention, as shown in Figs. 6-7, the present embodiment further provides a vacuum apparatus 200 for heating a tray. The vacuum apparatus 200 may include a chamber 210, a tray (not shown), a heating device 220, a support frame 100, and a lifting mechanism 230. The heating device 220 is disposed in the chamber 210 for supporting the tray and heating the tray. The support frame 100 is disposed in the chamber 210 and located below the heating device 220 for supporting the heating device 220.The lifting mechanism 230 is disposed outside the chamber 210, and a lifting rod of the lifting mechanism 230 extends from outside the chamber 210 into the chamber 210 to contact the support frame 100, so as to drive the support frame 100 to lift and lower in the chamber 210.

In the present embodiment, the vacuum apparatus 200 is used to heat the tray and requires vertical movement during heating. Therefore, four lifting mechanisms 230 are employed to support and drive the heating device 220 and the tray to lift and lower. Of course, in other embodiments, the number of lifting mechanisms 230 is not limited to four. In the present embodiment, the four lifting mechanisms 230 can only support four fulcrums of the heating device 220. During the temperature rise inside the chamber 210, the heating device 220 tends to sag and deform, resulting in non-uniform heating of the tray and further causing failure in subsequent product preparation.

In the present embodiment, with the support frame 100 described above, the lifting mechanisms 230 support the support frame 100, which in turn supports the heating device 220, and the heating device 220 supports the tray. Since the support frame 100 is provided with the main frame 110, a plurality of support bars 120, and support protrusions 130 disposed above the support bars 120, and the support protrusions 130 are in contact with the surface to be supported of the heating device 220, the heating device 220 can be fully supported so that it is not easily deformed, thereby ensuring uniform heating of the tray.

Specifically, the support protrusions 130 are disposed on the support frame 100 in the present embodiment. The arrangement of the support protrusions 130 can reduce the contact area with the heating device 220, decrease heat loss, and reduce friction when relative sliding occurs between the heating device 220 and the support frame 100.

Several specific embodiments are described in detail below.

### Embodiment 1

In this embodiment, as shown in Fig. 6, the vacuum apparatus 200 may include a chamber 210, a tray (not shown), four lifting mechanisms 230, a heating device 220, and a support frame 100.The lifting rods of the lifting mechanisms 230 extend from outside the chamber 210 into the chamber 210, so as to abut against the support frame 100, and the heating device 220 is supported by the support frame 100. In this embodiment, the lifting mechanisms 230 drive the support frame 100 and the heating device 220 to lift and lower. The support frame 100 is used to support the heating device 220 and prevent the heating device 220 from sagging and deforming during heating. The heating device 220 in this embodiment is a planar square structure.

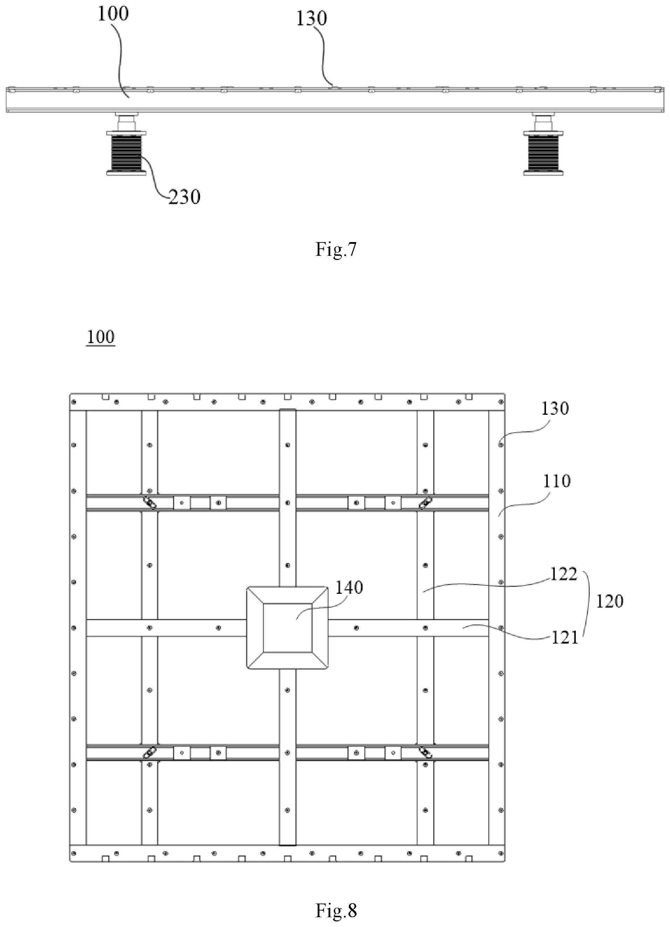

Specifically, as shown in Fig. 8, the support frame 100 in this embodiment may be formed by connecting a square main frame 110, three transverse support bars 121, and three longitudinal support bars 122 to each other, wherein the transverse support bars 121 and the longitudinal support bars 122 are cross-connected. Support protrusions 130 are uniformly arranged on the main frame 110 and the support bars 120, and the end surfaces of the support protrusions 130 are annular, i.e., the support protrusions 130 are of an annular cylindrical structure. A square passage 140 is provided at the central position of the main frame 110, and the passage 140 is formed by a frame structure connected with two support bars 120.The passage 140 is mainly used for wiring and routing of the heating device 220.The support frame 100 in this embodiment is made of H-section steel, which has high strength, low cost and is not easy to deform.

### Embodiment 2

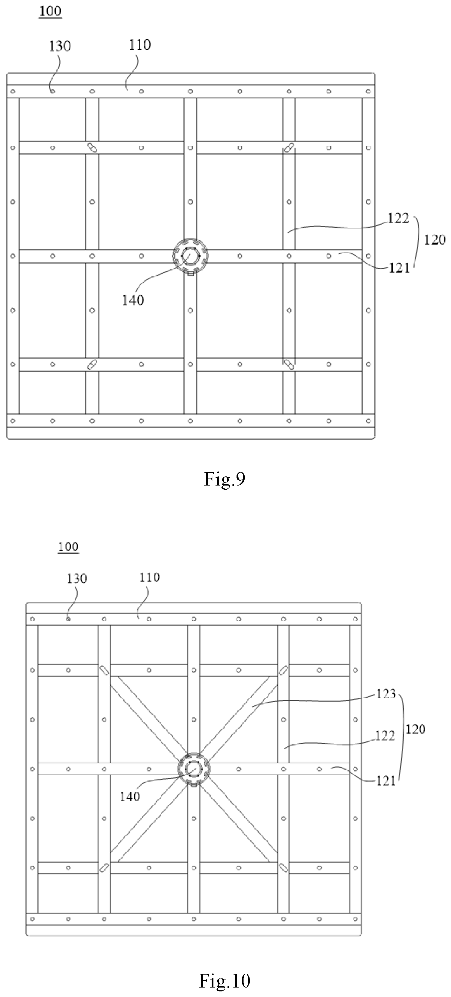

In this embodiment, as shown in Fig. 9, the structure of the support frame 100 differs from that of Embodiment 1 only in the structure of the passage 140. The passage 140 in this embodiment is a circular frame structure, which is connected to the main frame 110 via the support bars 120.

### Embodiment 3

In this embodiment, as shown in Fig. 10, compared with Embodiment 2, the support frame 100 is additionally provided with two oblique support bars 123. The two oblique support bars 123 are arranged to intersect each other and are connected at the intersection point to the frame structure forming the circular passage 140. The ends of the two oblique support bars 123 are respectively connected to the intersections of the support bars 120 near the main frame 110, so as to improve stability and strength.

### Embodiment 4

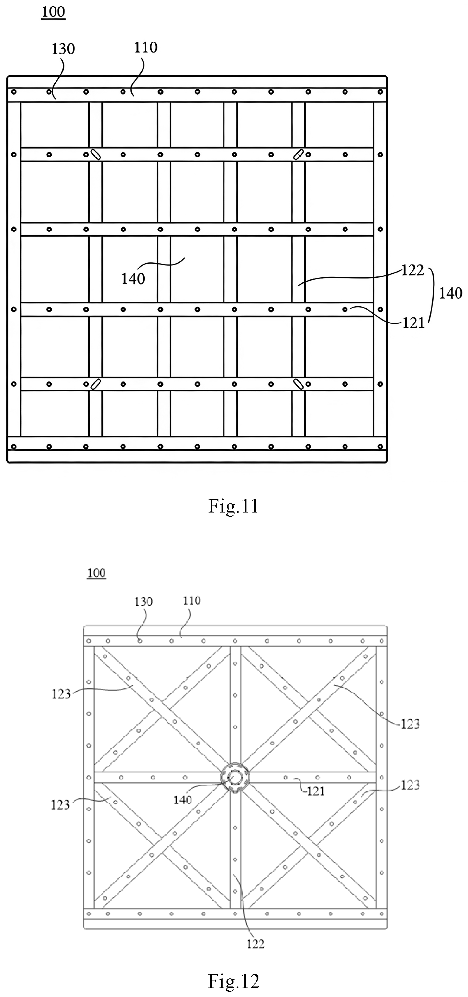

In this embodiment, the main structure of the vacuum apparatus 200 is the same as that of Embodiment 1, while the structure of the support frame 100 is different. As shown in Fig. 11, the support frame 100 in this embodiment includes a square main frame 110, four transverse support bars 121, and four longitudinal support bars 122. The four transverse support bars 121 and the four longitudinal support bars 122 are cross-connected , and the hole formed in the middle can be used as the passage 140.

### Embodiment 5

In this embodiment, the main structure of the vacuum apparatus 200 is the same as that of Embodiment 1, while the structure of the support frame 100 is different. As shown in Fig. 12, the support frame 100 in this embodiment is formed by connecting a square main frame 110, one transverse support bar 121, one longitudinal support bar 122, and six oblique support bars 123. The passage 140 in this embodiment is a circular frame structure disposed at the central position, and is connected to the main frame 110 via one transverse support bar 121, one longitudinal support bar 122, and two intersecting oblique support bars 123. Support protrusions 130 are uniformly arranged on the main frame 110 and the support bars, and the end surfaces of the support protrusions 130 are annular. The support frame 100 in this embodiment is made of H-section steel.

### Embodiment 6

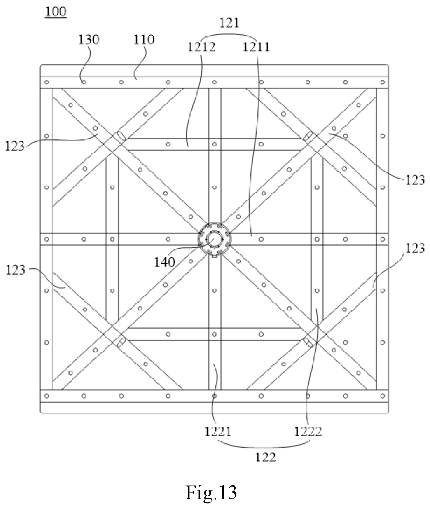

In this embodiment, the main structure of the vacuum apparatus 200 is the same as that of Embodiment 5, with only a slight difference in the internal structure of the support frame 100. As shown in Fig. 13, the support frame 100 in this embodiment may include a square main frame 110, three transverse support bars 121, three longitudinal support bars 122, and six oblique support bars 123. Except that the two intersecting oblique support bars 123 are the same as those in Embodiment 5, the positions of the other four oblique support bars 123 are slightly different from the corresponding ones in Embodiment 5, which will not be further described here. In addition, two more transverse support bars 121 and two more longitudinal support bars 122 are added in this embodiment to further enhance the stability and strength of the support frame 100 so as to prevent the object from deforming. In this embodiment, a passage 140 formed by a circular frame structure is located at the central position. Support protrusions 130 are uniformly arranged on the main frame 110 and the support bars, and the end surfaces of the support protrusions 130 are annular. The support frame 100 in this embodiment is made of H-section steel.

It can be seen from the above embodiments that the structure of the support frame 100 can be varied and designed according to actual conditions, but it must include the main frame 110, support bars, and support protrusions 130 disposed above the main frame 110 and the support bars. Through the design of the support frame 100, the heating device 220 in the vacuum apparatus 200 is not easily deformed at the operating temperature, so that the final heated product can be completely attached to the heating device 220, thereby achieving uniform heating.

By now, those skilled in the art should recognize that although a number of exemplary embodiments of the present invention have been illustrated and described in detail herein, many other variations or modifications consistent with the principles of the invention may be directly determined or derived from the disclosure herein without departing from the spirit and scope of the invention. Accordingly, the scope of the present invention should be understood and deemed to cover all such other variations or modifications.

## Claims

1. A support frame for supporting a heating device in a vacuum apparatus, the heating device having a surface to be supported, **characterized by** comprising:
a main frame;
a plurality of support bars uniformly arranged in the main frame; and
a plurality of support protrusions arranged on a plane of the main frame and/or the plurality of support bars facing the surface to be supported, wherein the support protrusions are in contact with the surface to be supported.

2. The support frame according to claim 1, wherein the support protrusions on the main frame are uniformly arranged, and the support protrusions on each of the support bars are uniformly arranged.

3. The support frame according to claim 2, wherein the plurality of support protrusions are arranged in central symmetry.

4. The support frame according to any one of claims 1 to 3, wherein an end of each support protrusion adjacent to the heating device is formed as a planar structure.

5. The support frame according to any one of claims 1 to 3, wherein the plurality of support bars intersect each other and form a centrally symmetric structure.

6. The support frame according to any one of claims 1 to 3, wherein the support frame is made of structural steel selected from one of H-section steel, rectangular steel, L-shaped angle steel, T-section steel, round steel, solid square steel or flat steel.

7. The support frame according to any one of claims 1 to 3, wherein the surface of the support frame further comprises at least one corrosion-resistant layer.

8. The support frame according to claim 1, wherein a passage is provided in the main frame to communicate two side surfaces of the support frame, and the passage is defined by the plurality of the support bars, or by a frame structure connected to the main frame via the support bars.

9. Vacuum apparatus, comprising the support frame according to any one of claims 1 to 8.

10. The vacuum apparatus according to claim 9, further comprising:
a chamber;
a tray;
a heating device arranged in the chamber for heating the tray; the support frame is arranged in the chamber and located below the heating device for supporting the heating device; and
a lifting mechanism arranged outside the chamber, wherein a lifting rod of the lifting mechanism extends from outside the chamber into the chamber to contact the support frame, so as to drive the support frame to move up and down in the chamber.
